# EUROPÄISCHE PATENTSCHRIFT

(11) **EP 2 529 424 B1**
(45) Veröffentlichungstag und Bekanntmachung des Hinweises auf die Patenterteilung: **22.02.2017**
(21) Anmeldenummer: 10796088.2
(22) Anmeldetag: 29.12.2010
(51) Int. Cl.: H01L 41/273, C04B 35/632

(54) **VERFAHREN UND GIESSSCHLICKER ZUR HERSTELLUNG VON PIEZOKERAMIK**
METHOD AND CASTING SLIP FOR PRODUCING PIEZOELECTRIC CERAMIC
PROCÉDÉ ET BARBOTINE POUR LA PRODUCTION DE CÉRAMIQUE PIÉZO-ÉLECTRIQUE

(30) Priorität: 27.01.2010 DE 102010001246
(43) Veröffentlichungstag der Anmeldung: 05.12.2012
(73) Patentinhaber: Robert Bosch GmbH, 70442 Stuttgart (DE)
(72) Erfinder: CROMME, Peter, 96050 Bamberg (DE)
(86) Internationale Anmeldenummer: PCT/EP2010/070879
(87) Internationale Veröffentlichungsnummer: WO 2011/091939

(56) Entgegenhaltungen:
- EP-A1- 0 907 212
- WO-A1-2006/000491
- CA-A1- 2 242 524
- CORKER D L ET AL: "PZT 'composite' ferroelectric thick films", JOURNAL OF THE EUROPEAN CERAMIC SOCIETY, Bd. 22, Nr. 3, 2002, Seiten 383-390, XP004312656, ISSN: 0955-2219
- QIANG L ET AL: "Preparation and microstructure analysis of Fe-doped PbTiO3 ceramic", FRONTIERS OF CHEMICAL ENGINEERING IN CHINA, Bd. 2, Nr. 2, Juni 2008 (2008-06), Seiten 140-144, XP002632634, ISSN: 1673-7369

## Beschreibung

### Stand der Technik

Die Erfindung betrifft einen Gießschlicker, zur Herstellung einer Piezokeramik als Bestandteil einer Piezolage für einen Piezoaktor oder ein Piezoaktormodul nach den gattungsgemäßen Merkmalen des Anspruchs 1 und die Herstellung eines Piezoaktors für ein Piezoaktormodul, insbesondere für die Anwendung in einem Piezoinjektor.

Es ist an sich bekannt, dass zum Aufbau eines zuvor erwähnten Piezoaktors Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen bestehend aus einer Piezokeramik mit einer beispielsweise durch Sintern und/oder Kalzinieren eines Ausgangsmaterials erzeugten geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

Ein Piezoaktor besteht dabei aus einem oder mehreren an ihren Stirnflächen miteinander typischerweise durch Laminieren miteinander verbundenen Piezoelementen sowie aus entlang dem Piezoelement verlaufenden Außenelektroden zur elektrischen Kontaktierung der Innenelektroden.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt- und mengengenauen Dosierung von Kraftstoff in periodisch arbeitenden Verbrennungsmotoren verwendet werden. Ein solcher Piezoinjektor besteht im Wesentlichen aus einem Haltekörper und einem in dem Haltekörper unter einer Druckvorspannung angeordneten Piezoaktormodul, bestehend aus einem Kopf- und einem Fußteil sowie einem zwischen Kopf- und Fußteil angeordneten Piezoaktor aus einem oder mehreren Piezoelementen. Das Kopfteil des Piezoaktormoduls ist mit einer Düsennadel verbunden, sodass durch Anlegen oder Wegnahme einer Spannung an die Piezoelemente eine Düsenöffnung freigegeben oder verschlossen wird. Das auch als Aktorkopf und Aktorfuß bezeichnete Kopf- und Fußteil sind an gegenüberliegenden Stirnflächen des Piezoaktors angeordnet.

Solche Piezoinjektoren sind beispielsweise aus der DE 103 53 169 A1, aus der DE 10 2006 045 663 A1 und aus der DE 10 2007 047 426 A1 bekannt.

Piezoaktoren nach dem Stand der Technik weisen typischerweise ein auch als interdigital bezeichnetes alternierendes Innenelektrodendesign mit einer einheitlichen Schichtdicke der Piezolagen über den gesamten, aus den Piezoelementen und den durch Innenelektroden eingeschlossenen umfassenden aktiven Bereich auf, an den sich an ihren den Fuß- und Kopfteilen des Piezoaktormoduls zugewandten Enden fußseitig und kopfseitig ein inaktiver bzw. passiver Bereich bestehend aus Piezolagen ohne Innenelektroden anschließt. Derartige Piezokeramiken bzw. Verfahren zu deren Herstellung sind beispielsweise durch die DE 28 37 508 C3, durch die DE 34 44 177 A1, durch die DE 198 40 488 A1 und durch die DE 10 2005 014 765 B4 bekannt.

Bei der eingangs erwähnten Piezokeramik sind präzise Verfahren zur Einstellen eines gewünschten Dotierlevels bei der Anwendung in den piezoelektrischen Aktoren, wie beispielsweise in den beschriebenen Injektoren für Brennstoffeinspritzanlagen, notwendig. Die Piezoaktoren mit der Piezokeramik werden dabei in an sich bekannter Weise in einem laminierten Aufbau hergestellt. Zunächst werden sogenannte Grünfolien, bestehend aus dem Rohmaterial Bleizirkonat-Titanat (PZT-Pulver), organischem Binder und Plastifizierer mit den späteren Innenelektroden bedruckt, gestapelt und zu einem monolithischen Körper verpresst bzw.laminiert. In den darauf folgenden Prozessschritten wird das organische Material aus den Grünfolien entfernt (Entbindern) und die Piezokeramik wird durch eine weitere thermische Behandlung verdichtet.

Die elektromechanische Leistungsfähigkeit des fertigen Piezoaktors wird im Wesentlichen durch das keramische Gefüge, insbesondere die Korngrößenverteilung und durch die Materialszusammensetzung des PZT-Pulvers hinsichtlich einer Verunreinigung und dem Gehalt an Dotierstoffen bestimmt. Allerdings weisen die hierbei verwendeten Rohstoffe bei der Herstellung von PZT-Pulver, wie PbO, ZrO₂ und TiO₂ schwankende Gehalte auch an ungewollten Verunreinigungen auf, wie z.B. Al₂O₃, BaO, CaO, Fe₂O₃, HfO₂, Na₂O, SiO₂, Y₂O₃ etc. Insbesondere beeinflussen hierbei sogenannte Glasbildner (z. B. SiO₂) und dreiwertige Ionen (Fe³⁺, Al³⁺, Y³⁺) die Sinteraktivität des PZT-Pulvers in starkem Maße, sodass in Abhängigkeit der eingesetzten Rohstoffchargen, durchaus Piezoaktoren mit unterschiedlichen elektromechanischen Eigenschaften hergestellt werden können.

CA 2 242 524 A1 offenbart einen Gießschlicker zur Herstellung einer Piezokeramik, die PZT enthält und eine Zudotierung von Eisen enthaltenden metallorganischen Verbindungen wie z.B. Fe-Acetat und Fe-Acetylacetonat enthält.

Das Fachblatt "Journal of the European Ceramic Society", Bd.22, Nr.3, 2002, Seiten 383-390 (XP004312656) offenbart einen Artikel "PZT 'composite' ferroelectric thick films", der Verfahren offenbart, bei denen einem dotierten PZT-Schlicker Mn- und Nb-Acetat zudotiert werden.

WO 2006/000491 A1 lehrt die Zugabe von Ammoniumeisencitrat nach dem Kalzinieren von SKN-PZT-Pulver, insbesondere zur Herstellung von Fe-dotierten monolithisch gesinterten Vielschichtaktoren mit Ag-haltigen Innenelektroden.

"FRONTIERTS OF CHEMICAL ENGINEERING IN CHINA", Bd.2, Nr.2, 2008, Seiten 140-144 (XP002632634) offenbart im Artikel "Preparation and microstructure analysis of Fe-doped PbTiO₃ ceramic" die Verwendung von Ferrocen zur Herstellung von Fe-dotierter Piezokeramik, wobei Ferrocen bereits der Ausgangslösung zur Herstellung des Rohpulvers beigefügt wird.

Die zuvor erwähnten Probleme stellen in der praktischen Anwendung einen Nachteil dar, da die Regelschleifen in der Piezoaktorfertigung häufig zu träge sind, um kurzfristig auf Materialschwankungen zu reagieren. Die Folge kann eine schwankende und schwer prognostizierbare Ausbringung von qualitativ ausreichenden Piezoaktoren in der Fertigung sein.

### Offenbarung der Erfindung

Die Erfindung geht von einem Gießschlicker zur Herstellung einer Piezokeramik mit Grünfolien aus, die aus einem Gießschlicker aus pulverförmigen Rohmaterial und Binde-, Plastifizier- und Lösungsmittel mit anschließendem Sintern hergestellt werden. Erfindungsgemäß erfolgt dabei in vorteilhafter Weise eine Zudotierung von metallorganischen Verbindungen in den Gießschlicker. Das pulverförmige Rohmaterial ist dabei vorzugsweise Bleizirkonat-Titanat (PZT). Mit der vorliegenden Erfindung wird somit ein Konzept vorgeschlagen, bei dem die Materialeigenschaften des PZT's durch eine Dotierung der Grünfolien vergleichmäßigt werden können. Als eine Aufgabe der Erfindung kann es somit angesehen werden, die Materialzusammensetzung und das keramische Gefüge der PZT-Piezokeramik in einem Piezoaktor zu homogenisieren, wodurch die elektromechanischen Eigenschaften der Piezoaktoren vergleichmäßigt werden und dadurch die sogenannte Gutausbringung und Qualität der Piezoaktoren verbessert werden kann.

Bei dem erfindungsgemäßen Gießschlicker sind die metallorganischen Verbindungen in den nichtwässrigen Lösungsmitteln bei der Herstellung der Grünfolien löslich, wobei ein organischer Rest der metallorganischen Verbindungen beim Entbindern der Grünfolie weitgehend rückstandsfrei entfernt wird.

Die Erfindung bezieht sich auf einen Gießschlicker zur Herstellung einer zuvor beschriebenen Piezokeramik, bei dem die metallorganischen Verbindungen im

Gießschlicker Eisen als Ferrocen (Dicyclopentadienyleisen) enthalten. Gießschlicker Eisen enthalten. Die metallorganischen enthalten Dicyclopentadienyl Gegenstand der Erfindung ist weiterhin ein Verfahren zur Herstellung eines Piezoaktors für ein Piezoaktormodul mit Piezolagen aus Piezokeramik, die wie vorhergehend beschrieben hergestellt werden, und mit zwischen der Piezokeramik angeordneten Innenelektroden versehen sind, die zur Herstellung eines Mehrlagenaufbaus aufeinandergestapelt und zu einem monolithischen Körper verpresst oder laminiert sind. Hieraus kann in vorteilhafter Weise ein Piezoinjektor mit einem Haltekörper und einem in dem Haltekörper angeordneten Piezoaktormodul gebildet werden, der insbesondere bei hohen Robustheits- und Lebensdaueranforderungen einsetzbar ist.

### Kurze Beschreibung der Zeichnung

Ein Ausführungsbeispiel der Erfindung ist in der Zeichnung dargestellt und im Folgenden näher beschrieben. Es zeigen:

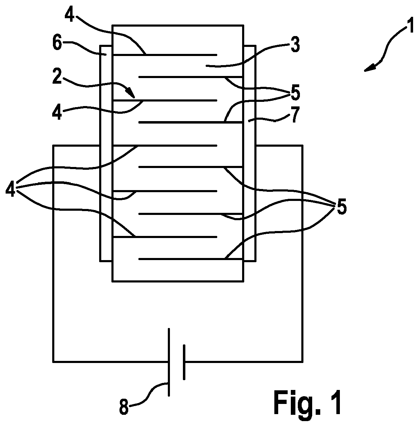

Fig. 1 eine schematische Darstellung eines Piezoaktors mit der erfindungsgemäßen Piezokeramik.

### Weg zu Ausführung der Erfindung

Ein in Figur 1 schematisch dargestellter, im mechanischen Aufbau an sich bekannter Piezoaktor 1 umfasst mehrere als Mehrlagenaufbau übereinandergestapelte Piezoelemente, die jeweils aus Piezolagen 3 aus Piezokeramik und diese einschließende Innenelektroden 4 und 5 bestehen. Der Piezoaktor 1 kann beispielsweise Bestandteil eines Piezoinjektors zur Steuerung der Kraftstoffeinspritzung bei einem Verbrennungsmotor sein. Die Innenelektroden 4 und 5 der Piezoelemente sind mit Außenelektroden 6 und 7 wechselseitig an eine Spannungsquelle 8 angeschlossen, sodass unter Ausnutzung des Piezoeffekts bei Anlage der elektrischen Spannung an die jeweiligen Innenelektroden 4 und 5 über die zwischenliegenden Piezolagen 3 eine mechanische Reaktion des Piezoaktors 1 in Stapelrichtung des Mehrlagenaufbaus bewirkt werden kann.

Im Folgenden wird ein Herstellungsverfahrung für die Piezokeramik der Piezolagen 3 beschrieben, die aus einer Grünfolie hergestellt werden und bei denen im Verlauf des Herstellungsprozesses eine Zudotierung in den Gießschlicker als Ausgangsmaterial der Grünfolien in Abhängigkeit der verwendeten PZT-Rohstoffchargen für die Grünfolien erfolgt.

Eine solche Zudotierung in den Gießschlicker hat den Vorteil, dass zunächst alle Prozessschritte bis einschließlich der Herstellung des PZT-Pulver aus vorzugsweise PbO, ZrO₂ und TiO₂ nicht verändert werden müssen. Je nach einem Verunreinigungsgrad des bezogenen PZT-Pulvers erfolgt erfindungsgemäß eine gezielte Zudotierung in den Gießschlicker zur Herstellung der Grünfolien. Diese Zudotierung kann somit flexibel und kostengünstig ohne großen Aufwand zu einem sehr späten Zeitpunkt in der Prozesskette bei der Herstellung des Piezoaktors 1 erfolgen.

Durch die Vergleichmäßigung des PZT-Pulvers wird der Prozess zur Herstellung der Piezoaktoren 1 nach der Figur 1 wesentlich vereinfacht. Es reicht hierbei, dass der Prozess auf die optimierten Grünfolien abgestimmt werden muss, sodass eine nachfolgende Prozesssteuerung der Piezoaktorfertigung aufgrund von PZT-Materialschwankungen nicht mehr notwendig ist.

Für eine effektive Zudotierung in den Gießschlicker müssen lediglich folgende Voraussetzungen erfüllt sein:
- Die Dotierstoffe müssen im Gießschlickersystem homogen mischbar sein.
- Es dürfen keine Agglomeration bzw. Entmischung der Dotierstoffe innerhalb der Verarbeitungszeit des Gießschlickers erfolgen.
- Die Dotierstoffe müssen eine gewisse Stabilität aufweisen, damit es zu keinen ungewollten (chemischen) Reaktionen wahrend der Gießschickeraufbereitung kommt, z. B. zu explosionsartige Zersetzung in Verbindung mit Luftfeuchtigkeit.

Die erfindungsgemäßen metallorganische Verbindungen bestehen dabei in der Regel aus einem Metallion oder Metallatom mit einem metallorganischen Rest und erfüllen dabei diese Voraussetzungen nahezu ideal. Hierbei sind eine Vielzahl von metallorganischen Verbindungen in nicht wässrigen Lösungsmitteln löslich, wie sie bei der Gießschlickerherstellung benötigt werden. Solche Lösungen von metallorganischen Verbindungen sind weiterhin molekular dispers, d. h. optimal und homogen verteilt. Der organische Rest der metallorganischen Verbindungen wird beim Entbindern rückstandfrei entfernt, sodass nur noch die reinen Dotierstoffe während des Sintervorganges des Piezoaktors vorliegen. Aufgrund der atomar- bzw. molekulardispersen Verteilung weisen die erfindungsgemäßen Dotierstoffe eine hohe Diffusionsgeschwindigkeit auf und können entsprechend ihres Wirkungsmechanismus an den Korngrenzen und/ oder auf entsprechenden Gitterplätzen in der PZT-Keramik ihre Wirkung während des Sintervorganges entfalten.

## Patentansprüche

1. Gießschlicker zur Herstellung einer Piezokeramik mit Grünfolien, die aus einem Gießschlicker aus pulverförmigen Rohmaterial und Binde- Plastifizier- und Lösungsmittel mit anschließendem Sintern hergestellt werden, wobei in den Gießschlicker eine Zudotierung von metallorganischen Verbindungen erfolgt, **dadurch gekennzeichnet, dass** die metallorganischen Verbindungen im Gießschlicker Eisen als Ferrocen (Dicyclopentadienyleisen) enthalten.

2. Gießschlicker nach Anspruch 1, **dadurch gekennzeichnet, dass** das pulverförmige Rohmaterial Bleizirkonat-Titanat (PZT) ist.

3. Gießschlicker nach Anspruch 1 oder 2, **dadurch gekennzeichnet, dass** die metallorganischen Verbindungen in nichtwässrigen Lösungsmitteln bei der Herstellung der Grünfolien löslich sind, wobei ein organischer Rest der metallorganischen Verbindungen beim Entbindern der Grünfolie weitgehend rückstandsfrei entfernt wird.

4. Verfahren zur Herstellung eines Piezoaktors (1) für ein Piezoaktormodul bestehend aus Piezolagen (3) aus Piezokeramik, die mit Gießschlicker nach einem der Ansprüche 1 bis 3 hergestellt ist, mit zwischen den Piezolagen (3) angeordneten Innenelektroden (4,5), die zur Herstellung eines Mehrlagenaufbaus aufeinandergestapelt und zu einem monolithischen Körper verpresst oder laminiert sind.

## Claims

1. Casting slip for producing a piezoceramic using green sheets which are produced from a casting slip composed of pulverulent raw material and binder, plasticizer and solvent with subsequent sintering, where metal-organic compounds are added as dopants to the casting slip, **characterized in that** the metal-organic compounds in the casting slip contain iron as ferrocene (dicyclopentadienyliron).

2. Casting slip according to Claim 1, **characterized in that** the pulverulent raw material is lead zirconate titanate (PZT).

3. Casting slip according to Claim 1 or 2, **characterized in that** the metal-organic compounds are soluble in nonaqueous solvents in the production of the green sheets and an organic radical of the metal-organic compounds is removed largely without leaving a residue during binder removal from the green sheet.

4. Process for producing a piezoactuator (1) for a piezoactuator module consisting of piezoelectric layers (3) composed of piezoceramic produced using a casting slip according to any of Claims 1 to 3 with internal electrodes (4, 5) arranged between the piezoelectric layers (3), which are stacked on top of one another to produce a multilayer structure and pressed or laminated together to give a monolithic body.

## Revendications

1. Barbotine pour la fabrication d'une céramique piézoélectrique à feuilles vertes, qui est fabriquée à partir d'une barbotine en une matière première en poudre et de liants, plastifiants et solvants, avec un frittage ultérieur, un dopage avec des composés métallo-organique ayant lieu dans la barbotine, **caractérisée en ce que** les composés métallo-organiques dans la barbotine contiennent du fer en tant que ferrocène (dicyclopentadiényl-fer).

2. Barbotine selon la revendication 1, **caractérisée en ce que** la matière première en poudre est le zirconate-titanate de plomb (PZT).

3. Barbotine selon la revendication 1 ou 2, **caractérisée en ce que** les composés métallo-organiques sont solubles dans les solvants non aqueux lors de la fabrication des feuilles vertes, un radical organique des composés métallo-organiques étant éliminé essentiellement sans résidu lors du déliage de la feuille verte.

4. Procédé de fabrication d'un actionneur piézoélectrique (1) pour un module d'actionneur piézoélectrique constitué par des couches piézoélectriques (3) en céramique piézoélectrique, qui est fabriquée avec une barbotine selon l'une quelconque des revendications 1 à 3, avec des électrodes intérieures (4, 5) agencées entre les couches piézoélectriques (3), qui sont empilées les unes sur les autres et comprimées ou stratifiées en un corps monolithique pour la fabrication d'une structure multicouche.
